(19) Europäisches Patentamt
European Patent Office
Office européen des brevets

(11) **EP 4 726 769 A1**

(12) **EUROPEAN PATENT APPLICATION**

(43) Date of publication:
**15.04.2026 Bulletin 2026/16**

(21) Application number: **25206103.1**

(22) Date of filing: **01.10.2025**

(51) International Patent Classification (IPC):
***H01J 37/28*** *(2006.01)*      ***H01J 37/244*** *(2006.01)*

(52) Cooperative Patent Classification (CPC):
**H01J 37/28; H01J 37/244;** H01J 2237/24465;
H01J 2237/24475; H01J 2237/2814

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **11.10.2024 JP 2024178569**

(71) Applicant: **Jeol Ltd.
Akishima, Tokyo 196-8558 (JP)**
(72) Inventors:
• **OTSUKA, Takeshi
Tokyo, 196-8558 (JP)**
• **NAGOSHI, Tatsuro
Tokyo, 196-8558 (JP)**
• **NAGATOMO, Kei
Tokyo, 196-8558 (JP)**

(74) Representative: **Boult Wade Tennant LLP
Salisbury Square House
8 Salisbury Square
London EC4Y 8AP (GB)**

(54) **SCANNING ELECTRON MICROSCOPE AND GRADIENT MAP GENERATION METHOD**

(57)     A calculator (41) calculates gradient information based on a detection value set acquired from each micro-surface of a sample. A gradient map is formed from a plurality of sets of gradient information corresponding to a plurality of micro-surfaces. Each set of gradient information includes information which identifies an azimuth angle of each micro-surface. A corrector (42) corrects each set of gradient information so that the azimuth angle of each micro-surface is corrected according to a current sample observation condition. The azimuth angle and an inclination angle may be corrected sequentially or simultaneously.

FIG. 1

EP 4 726 769 A1

## Description

TECHNICAL FIELD

The present disclosure relates to a scanning electron microscope and a gradient map generation method, and in particular to a technique for correcting a gradient map reflecting a shape of a surface of a sample.

BACKGROUND

A scanning electron microscope is one type of charged particle beam apparatus. Known three-dimensional shape reconstruction methods using the scanning electron microscope include a method utilizing backscattered electrons and a method utilizing secondary electrons. In the following, a three-dimensional shape reconstruction method utilizing the backscattered electrons will be described.

A typical segmented backscattered electron detector provided on the scanning electron microscope has a detection surface formed from four detection regions. During the process of two-dimensional scanning of electron beams on a sample, backscattered electrons are emitted from a micro-surface which is present at each position of the sample. The backscattered electrons are detected by the segmented backscattered electron detector. Depending on a gradient state of the micro-surface receiving the electron beam (and emitting the backscattered electrons), a backscattered electron distribution on the detection surface of the segmented backscattered electron detector varies. The gradient state of the micro-surface more specifically refers to a direction of gradient and a magnitude of gradient of the micro-surface. Based on four detection signals which are output from the four detection regions, gradient information representing the gradient state of the micro-surface is calculated.

The direction of gradient of the micro-surface is more specifically identified as an azimuth angle of the micro-surface, and the magnitude of gradient of the micro-surface is more specifically identified as an inclination angle. Typically, the azimuth angle is a rotational angle about an axis parallel to an optical axis, and the inclination angle is an intersecting angle with respect to the axis parallel to the optical axis. Alternatively, the azimuth angle and the inclination angle may be defined with reference to an axis other than the optical axis.

A gradient map is formed by a plurality of sets of gradient information corresponding to a plurality of positions (that is, a plurality of micro-surfaces) on the sample surface. A three-dimensional shape of the sample is reconstructed by applying a known integration process on the gradient map (for example, refer to JP 2006-172919 A and JP 2022-185757 A). As such a three-dimensional shape reconstruction method, there are known a photometric stereo method, a shading method, and the like.

The three-dimensional shape reconstruction method of the related art presumes that the backscattered electrons emitted from the sample move straight toward the detection surface of the segmented backscattered electron detector. However, research by the present inventors has revealed that this presumption may not be true, depending on sample observation conditions.

Specifically, in cases such as a case where the sample is positioned close to an objective lens, a case where a magnetic field of high strength is induced at the objective lens due to a high acceleration voltage, a case where a particular objective lens (for example, a semi-in-lens) is used, and the like, a leakage magnetic field from the objective lens applies an unignorable action on the backscattered electrons emitted from the sample. More specifically, the leakage magnetic field causes the backscattered electrons to deflect, resulting in an error in the calculated azimuth angle. This problem may also be caused when the gradient map is generated using secondary electrons or the like.

An advantage of the present disclosure lies in improvement of accuracy of the gradient map. Alternatively, an advantage of the present disclosure lies in reduction or removal of an azimuth angle error caused by the leakage magnetic field from the objective lens. Alternatively, an advantage of the present disclosure lies in provision of a novel technique for correcting the gradient map.

SUMMARY

According to one aspect of the present disclosure, there is provided a scanning electron microscope comprising: a detector that detects electrons emitted from each micro-surface of a sample during a process of scanning an electron beam on the sample, and that has a plurality of detection regions; a calculator that calculates a gradient map formed from a plurality of sets of gradient information representing gradient states of a plurality of micro-surfaces of the sample, based on a plurality of detection signals which are output from the plurality of detection regions; and a corrector that corrects the gradient map, wherein each of the sets of gradient information includes information which identifies an azimuth angle of each of the micro-surfaces, and the corrector corrects each of the sets of gradient information so that the azimuth angle of each of the micro-surfaces is corrected according to a current sample observation condition.

According to another aspect of the present disclosure, there is provided a method of generating a gradient map, the method comprising: detecting, with a plurality of detection regions, electrons emitted from each micro-surface of a sample during a process of scanning a charged particle beam on the sample; and generating a gradient map formed from a plurality of sets of gradient information representing gradient states of a plurality of micro-surfaces of the sample, based on a plurality of detection signals which are output from the plurality of detection regions, wherein each of the sets of gradient information includes information which identifies an azimuth angle of each of the micro-surfaces, and, in the generating the gradient map, each of the sets of gradient information is corrected so that the azimuth angle of each of the micro-surfaces is corrected according to a current sample observation condition.

BRIEF DESCRIPTION OF DRAWINGS

Embodiment(s) of the present disclosure will be described based on the following figures, wherein:

FIG. 1 is a block diagram showing an example structure of a scanning electron microscope according to an embodiment of the present disclosure;
FIG. 2 is a plan view showing an example of a detection surface of a detector;
FIG. 3 is a cross-sectional diagram showing a sample surface and a micro-surface;
FIG. 4 is a diagram showing emission of electrons from the micro-surface;
FIG. 5 is a diagram showing a coordinate system;
FIG. 6 is a diagram showing a gradient vector corresponding to gradient information;
FIG. 7 is a diagram showing a plurality of gradient vectors corresponding to a plurality of micro-surfaces;
FIG. 8 is a diagram showing an example of a gradient map:
FIG. 9 is a diagram showing a straight-line electron trajectory;
FIG. 10 is a diagram showing an electron trajectory which is curved due to influences of a leakage magnetic field;
FIG. 11 is a diagram showing an example of a correction function according to a first example configuration of the present disclosure;
FIG. 12 is a diagram showing an example of a correction table according to the first example configuration of the present disclosure;
FIG. 13 is a flowchart showing an operation according to an embodiment of the present disclosure;
FIG. 14 is a diagram showing a three-dimensional shape generated based on a gradient map before correction;
FIG. 15 is a diagram showing a three-dimensional shape generated based on a corrected gradient map;
FIG. 16 is a diagram showing a correction table according to a second example configuration of the present disclosure;
FIG. 17 is a diagram showing a correction table according to a third example configuration of the present disclosure;
FIG. 18 is a flowchart showing a method of calculating a correction value through an experiment;
FIG. 19 is a diagram showing calculation of the correction value using a sphere;
FIG. 20 is a diagram showing calculation of the correction value using a simulator;
FIG. 21 is a diagram showing a plurality of spheres distributed in a scanning region;
FIG. 22 is a diagram showing a labeling process with respect to a backscattered electron image;
FIG. 23 is a diagram showing a plurality of horizontal lines which are set for a plurality of regions;
FIG. 24 is a diagram showing a two-dimensional azimuth angle correction function; and
FIG. 25 is a diagram showing a two-dimensional inclination angle correction function.

DESCRIPTION OF EMBODIMENTS

An embodiment of the present disclosure will now be described with reference to the drawings.

(1) Overview of Embodiment

A scanning electron microscope according to an embodiment of the present disclosure comprises a detector, a calculator, and a corrector. The detector detects electrons emitted from each micro-surface of a sample during a process of scanning an electron beam on the sample, and has a plurality of detection regions. The calculator calculates a gradient map formed from a plurality of sets of gradient information representing gradient states of a plurality of micro-surfaces of the sample, based on a plurality of detection signals which are output from the plurality of detection regions. The corrector corrects the gradient map. Each of the sets of gradient information includes information which identifies an azimuth angle of each of the micro-surfaces. The corrector corrects each of the sets of gradient information so that the azimuth angle of each of the micro-surfaces is corrected according to a current sample observation condition. In the embodiment, a processor functions as the calculator and the corrector.
According to the above-described structure, with the correction of the gradient map, an azimuth angle error included in each set of gradient information can be reduced or removed. Thus, it becomes possible, for example, to more accurately reconstruct the three-dimensional shape of the sample based on the gradient map.

When a leakage magnetic field from an objective lens acts on the electrons emitted from each micro-surface (emitted electrons), an azimuth angle error is caused in the calculation of the gradient information. A degree of the action of the leakage magnetic field; that is, a degree of the azimuth angle error, varies depending on a sample observation condition (current sample observation condition) which is set for the scanning electron microscope during the observation of the sample. In consideration of this, in the above-described structure, the current sample observation condition (which may alternatively be called a current sample measurement condition) is taken into consideration when correcting the gradient map. The current sample observation condition may include, for example, a parameter that affects the strength of the leakage magnetic field, a parameter which defines a spatial relationship between the leakage magnetic field and the emitted electrons, and the like.

Each micro-surface is a local region which receives an electron beam and emits electrons. The electrons emitted from each micro-surface are, for example, backscattered electrons. The plurality of detection regions are at least three detection regions. The gradient state of the micro-surface refers to a direction of gradient and an amount of gradient of the micro-surface. The direction of gradient of the micro-surface is represented as the azimuth angle of the micro-surface, and the magnitude of gradient of the micro-surface is represented as the inclination angle of the micro-surface. Normally, the gradient map is corrected after the gradient map is generated, but alternatively, the generation of the gradient map and the correction of the gradient map may be performed simultaneously.

In an embodiment of the present disclosure, the corrector corrects each of the sets of gradient information based on azimuth angle correction information corresponding to the current sample observation condition. The azimuth angle correction information is generated in advance or is generated during correction of the gradient map.

In an embodiment of the present disclosure, the azimuth angle correction information includes an azimuth angle correction value which is applied in common to the plurality of micro-surfaces. According to this structure, the correction of the gradient map can be performed simply. Alternatively, the azimuth angle correction information includes a plurality of azimuth angle correction values which are applied to the plurality of micro-surfaces. According to this structure, the accuracy of the corrected gradient map can be further improved. When the azimuth angle error varies significantly in the scanning region, desirably, a plurality of azimuth angle correction values corresponding to a plurality of coordinates in the scanning region are prepared.

In an embodiment of the present disclosure, the azimuth angle correction information is information acquired in advance through an experiment or a simulation under a sample observation condition corresponding to the current sample observation condition, or information generated from the information acquired in advance. In the experiment, the scanning electron microscope is used. In the simulation, a simulator (normally, a computer) is used.

A scanning electron microscope according to an embodiment of the present disclosure further comprises a storage unit that stores a plurality of sets of azimuth angle correction information acquired by repeating experiments or simulations while sequentially setting a plurality of sample observation conditions. The storage unit includes a memory. The corrector identifies the azimuth angle correction information corresponding to the current sample observation condition based on the plurality of sets of azimuth angle correction information. In an embodiment of the present disclosure, the current sample observation condition includes at least one of an acceleration voltage or a working distance.

In an embodiment of the present disclosure, each of the sets of gradient information further includes information which identifies an inclination angle of each of the micro-surfaces. The corrector corrects each of the sets of gradient information so that both the azimuth angle and the inclination angle of each of the micro-surfaces are corrected. An angle of incidence of the electron beam changes depending on a position in the scanning region. The change of the angle of incidence causes an inclination angle error. According to the above-described structure, both the azimuth angle error and the inclination angle error are reduced, and thus, the accuracy of the gradient map can be further improved. Alternatively, correction with respect to the inclination angle error caused by other factors may be performed.

In an embodiment of the present disclosure, the corrector corrects each of the sets of gradient information so that the inclination angle of each of the micro-surfaces is corrected based on an inclination angle correction value corresponding to each of the micro-surfaces.

According to another aspect of the present disclosure, there is provided a method of generating a gradient map, comprising a detection step and a generation step. In the detection step, electrons emitted from each micro-surface of a sample during a process of scanning a charged particle beam on the sample are detected with a plurality of detection regions. In the generation step, a gradient map formed from a plurality of sets of gradient information representing gradient states of a plurality of micro-surfaces of the sample is generated based on a plurality of detection signals which are output from the plurality of detection regions. Each of the sets of gradient information includes information which identifies an azimuth angle of each of the micro-surfaces. In the generation step, each of the sets of gradient information is corrected so that the azimuth angle of each of the micro-surfaces is corrected according to a current sample observation condition.

The above-described method of generating the gradient map is performed by a charged particle beam apparatus. The correction of the gradient map may be executed after the gradient map is generated, or the generation of the gradient map and the correction of the gradient map may be performed simultaneously. The charged particle beam which is illuminated on the sample is, for example, an electron beam, an ion beam, or the like.

(2) Details of Embodiment

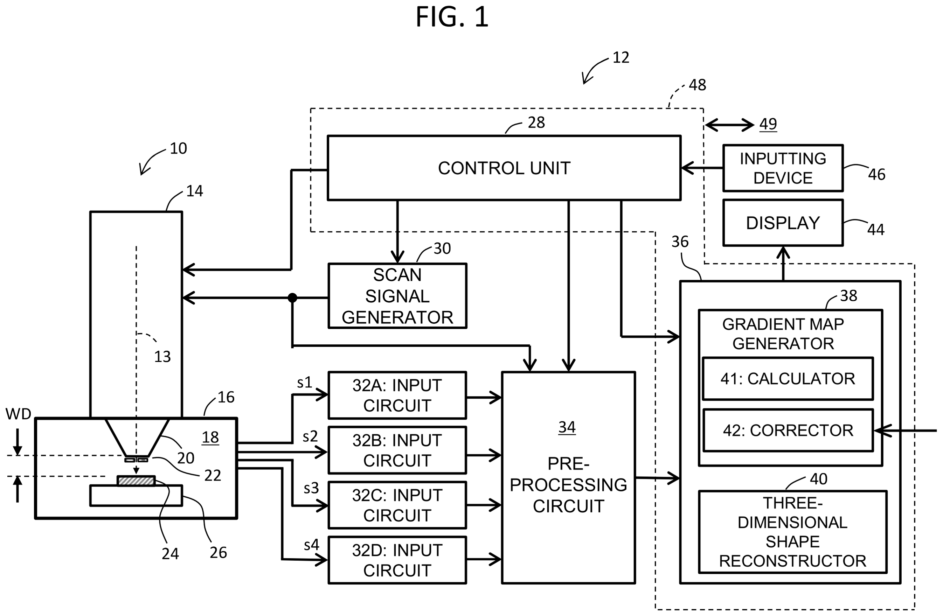

FIG. 1 shows a scanning electron microscope according to an embodiment of the present disclosure. The illustrated scanning electron microscope has a function to construct (reconstruct) a three-dimensional shape of a sample surface through detection of backscattered electrons emitted from the sample. Alternatively, secondary electrons may be detected in place of the backscattered electrons.

The scanning electron microscope has a measurement unit 10 and a calculation control unit 12. The measurement unit 10 corresponds to an observation unit. The measurement unit 10 has an optical column 14 and a housing 16. The housing 16 supports the optical column 14. In the optical column 14, an electron gun, a converging lens, a scanning coil, an objective lens, and the like are housed. These elements constitute a piece of equipment for scanning an electron beam 13 while illuminating the electron beam 13 onto a sample 24. An internal space of the housing 16 is a sample chamber 18. In the sample chamber 18, a movable stage 26 is provided. The movable stage 26 holds a sample 24. With the movable stage 26, a position and an orientation of the sample 24 are changed.

A lower end of an objective lens 20 extends into the sample chamber 18. A detector 22 is provided near a lower end surface of the objective lens 20. Alternatively, the detector 22 may be attached on the objective lens 20. The detector 22 is a backscattered electron detector, and is more specifically a segmented backscattered electron detector. A detection surface of the detector 22 is segmented into four segments in the illustrated example structure. That is, the detector 22 has four detection regions. In the example structure illustrated in FIG. 1, four detection signals s1, s2, s3, and s4 are output in parallel with each other from the four detection regions.

A distance from the lower end surface (or a reference level) of the objective lens 20 to the surface of the sample 24 (that is, the focal point of the electron beam) is called a working distance (WD). In FIG. 1, illustration of a secondary electron detector, an X-ray detector, or the like is omitted.

The calculation control unit 12 will now be described. In the embodiment of the present disclosure, the calculation control unit 12 includes a computer serving as an information processing apparatus. Reference numeral 48 indicates a processor. The processor 48 is, for example, a CPU which executes a program. In FIG. 1, a plurality of functions realized by the processor 48 are expressed with a plurality of blocks. The calculation control unit 12 has a storage unit. More specifically, a memory 49 serving as the storage unit is connected to the processor 48. The memory 49 stores information for generating and correcting the gradient map.

A control unit 28 controls operations of various elements of the scanning electron microscope. A scan signal generator 30 generates a scan signal to be supplied to the scanning coil in the optical column 14. The scan signal is also supplied to a pre-processing circuit 34.

The four detection signals s1 to s4 are input in parallel with each other to four input circuits 32A to 32D. Each of the input circuits 32A to 32D has a pre-amplifier, an I/V converter, and the like. The I/V converter converts a current signal to a voltage signal. Four detection signals which are output in parallel with each other from the four input circuits 32A to 32D are sent to the pre-processing circuit 34.

The pre-processing circuit 34 has four A/D converters. Each A/D converter converts each detection signal (analog signal) into a detection value string (digital signal). In the pre-processing unit 34, a respective detection value set is correlated to each coordinate identified by the scan signal. A detection value set which is correlated to a certain coordinate is formed from the four detection values S1, S2, S3, and S4 acquired from the coordinate.

A data processor 36 has a gradient map generator 38 and a three-dimensional shape reconstructor 40. The gradient map generator 38 is a module which generates the gradient map, and has a calculator 41 and a corrector 42.

The calculator 41 calculates, for each coordinate in the scanning region, gradient information representing a gradient state of a micro-surface present in the coordinate, based on the detection value set corelated to the coordinate. A gradient map is formed by a plurality of sets of gradient information corresponding to a plurality of coordinates. Each set of gradient information is more specifically a gradient vector defined by an x-direction gradient magnitude and a y-direction gradient magnitude.

The corrector 42 corrects the gradient map according to a sample observation condition which is set in the measurement unit 10 at the time of observation of the sample (current sample observation condition). In the example structure illustrated in FIG. 1, the corrector 42 individually corrects the plurality of sets of gradient information corresponding to the plurality of coordinates based on a combination of a plurality of setting values defining the current sample observation condition.

Specifically, the corrector 42 determines an azimuth angle correction value which is applied in common to the plurality of coordinates, based on, for example, a combination of a current acceleration voltage and a current WD. In this process, a correction function or a correction table stored in the memory 49 is utilized. Then, the corrector 42 corrects each gradient information based on the determined azimuth angle correction value, so that an azimuth angle error caused in each coordinate is reduced or removed. This process will be described later in detail. In the correction of the gradient map, reference may be made to one of the current acceleration voltage and the current WD, or to other setting values such as magnification, along with the current acceleration voltage and the current WD.

The three-dimensional shape reconstructor 40 reconstructs the three-dimensional shape of the sample surface based on the corrected gradient map. More specifically, the three-dimensional shape reconstructor 40 applies an integration process on the corrected gradient map, and generates a three-dimensional shape as a result thereof. A method itself of reconstructing the three-dimensional shape based on the gradient map is a known technique.

A display 44 is formed from, for example, an LCD. On a screen of the display 44, an SEM image (a backscattered electron image, a secondary electron image, or the like), an image representing the three-dimensional shape of the sample surface, or the like is displayed. An inputting device 46 is connected to the control unit 28. The inputting device 46 includes a keyboard, a pointing device, or the like.

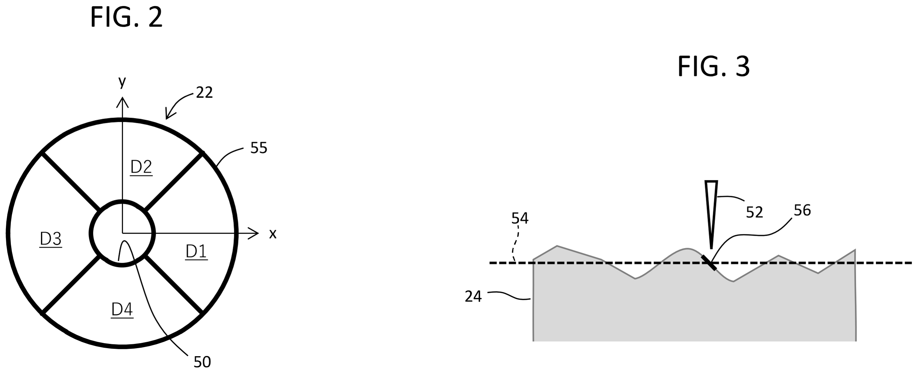

FIG. 2 shows a detection surface 55 of the detector 22 illustrated in FIG. 1. As described above, the detection surface 55 is formed from four detection regions D1, D2, D3, and D4. Each of the detection regions D1, D2, D3, and D4 has a fan-shaped form. An x direction is a first horizontal direction, and a y direction is a second horizontal direction. The two detection regions D1 and D3 are aligned in the x direction, and the two detection regions D2 and D4 are aligned in the y direction. The detector 22 has an opening 50 through which the electron beam passes. Alternatively, the detection surface 55 may be formed from three detection regions, or from five or more detection regions.

The gradient map will now be described with reference to FIGs. 3 to 8.

FIG. 3 shows a vertical cross section of the sample 24. The surface of the sample 24 has a three-dimensional shape. An average surface defined with respect to the surface of the sample 24 is a sample surface 54. In the illustrated example configuration, the sample surface 54 is a surface orthogonal to an optical axis.

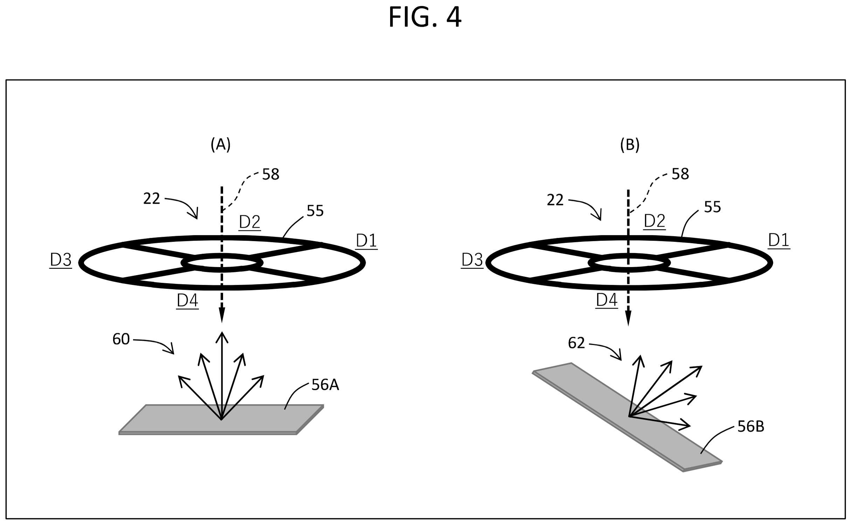

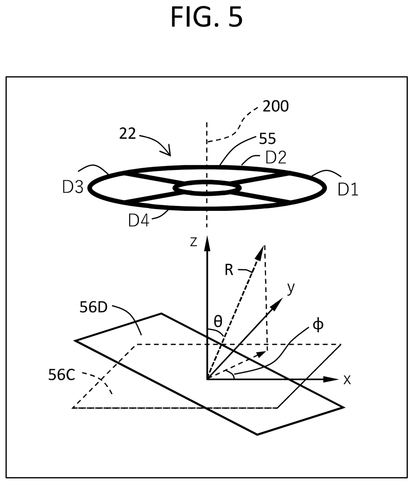

A surface which receives an electron beam 52 and emits backscattered electrons is a micro-surface 56. The micro-surface 56 may alternatively be called an electron beam incidence surface. In FIG. 3, the micro-surface 56 is expressed in an exaggerated manner. The same is also applicable to FIGs. 4, 5, and the like to be described below.

In FIG. 4, a part (A) shows a first backscattered electron emission state, and a part (B) shows a second backscattered electron emission state. In either state, the sample surface and the detection surface 55 are parallel to each other. An electron beam 58 (which may also be called an optical axis) passes through a center of the detector 22. The sample surface and the electron beam 58 are orthogonal to each other.

In the first backscattered electron emission state, a line normal to a micro-surface 56A is parallel to the electron beam 58. A group of backscattered electrons 60 emitted from the micro-surface 56A reach the four detection regions D1, D2, D3, and D4 forming the detection surface 55 of the detector 22 in approximately the same manner.

In the second backscattered electron emission state, a line of normal of a micro-surface 56B is inclined with respect to the electron beam 58. A group of backscattered electrons 62 emitted from the micro-surface 56B reach the detection surface 55 of the detector 22 in different manners. More specifically, in the illustrated example structure, a detection value acquired from the detection region D1 is the largest, a detection value acquired from the detection region D3 is the smallest, and two detection values acquired from two detection regions D2 and D4 are intermediate values, and are approximately equal to each other. The four detection values; that is, the detection value set, are information representing the gradient state (gradient direction and gradient amount) of the micro-surface.

FIG. 5 shows a coordinate system. For the purpose of simplifying the explanation, in FIG. 5, the sample surface is orthogonal to an optical axis 200, and the detection surface 55 of the detector 22 is parallel to the sample surface. The optical axis 200 passes through the center of the detector 22. A z axis is an axis parallel to the optical axis 200. An x axis corresponds to a direction of alignment of the detection regions D1 and D3, and a y axis corresponds to a direction of alignment of the detection regions D2 and D4. The x axis, the y axis, and the z axis are orthogonal to one another.

Reference numeral 56C shows a micro-surface parallel to the sample surface. Reference numeral 56D shows a micro-surface which is inclined. A line-of-normal vector R corresponds to a line normal to the gradient micro-surface 56D. As illustrated, the gradient direction of the micro-surface 56D is represented by an azimuth angle $\varphi$. The azimuth angle $\varphi$ is a rotational angle about an axis parallel to the optical axis 200.

The gradient magnitude of the micro-surface 56 is represented by an inclination angle $\theta$. The inclination angle $\theta$ is an intersecting angle of the line-of-normal vector R with respect to the axis parallel to the optical axis. Alternatively, a coordinate system other than the coordinate system illustrated in FIG. 5 may be used.

Several calculation equations are proposed for calculating the gradient information of the micro-surface based on the detection value set acquired from the micro-surface. In the embodiment of the present disclosure, the following Equations (1-1) and (1-2) are used.

[Equation 1]

$$G_x = k\frac{S1 - S3}{S1 + S3} \qquad \ldots (1\text{-}1)$$

$$G_y = k\frac{S2 - S4}{S2 + S4} \qquad \ldots (1\text{-}2)$$

A parameter Gx represents a gradient magnitude (gradient component) in the x direction, and a parameter Gy represents a gradient magnitude (gradient component) in the y direction. A gradient vector is defined by the two gradient magnitude. The gradient vector corresponds to the gradient information. A parameter S1 represents a detection value acquired from the detection region D1. Similarly, a parameter S2 represent a detection value acquired from the detection region D2, a parameter S3 represents a detection value acquired from the detection region D3, and a parameter S4 represents a detection value acquired from the detection region D4. A parameter k represents a conversion coefficient.

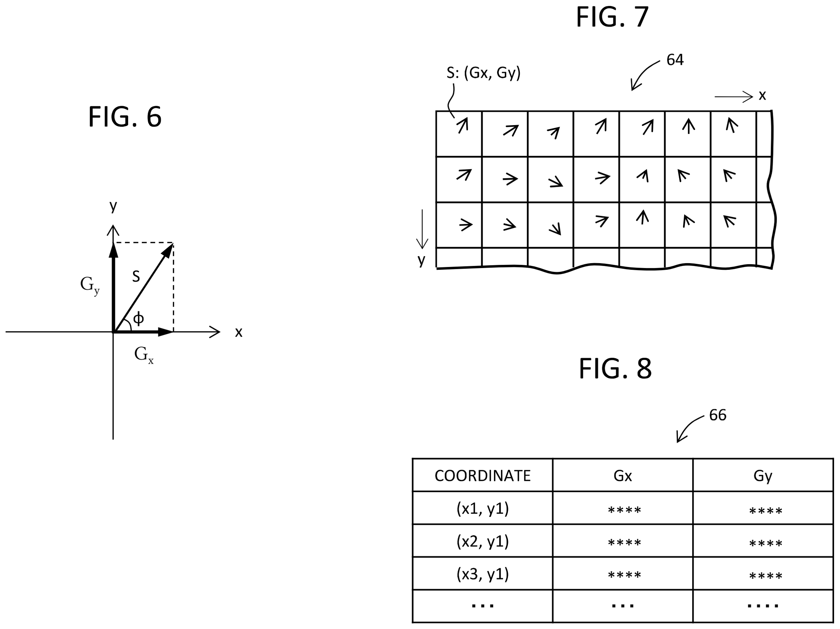

FIG. 6 shows a gradient vector S defined by Gx and Gy described above. A direction of the gradient vector S represents the azimuth angle φ of the micro-surface. A magnitude of the vector S represents the magnitude of the inclination angle θ of the micro-surface.

In the process of two-dimensional scanning of the electron beam, a plurality of detection value sets corresponding to a plurality of coordinates are sequentially acquired. For each coordinate, the gradient vector (that is, the gradient information of the micro-surface) is calculated based on the detection value set acquired from the coordinate. A matrix formed by a plurality of gradient vectors corresponding to a plurality of coordinates is the gradient map.

FIG. 7 shows a gradient vector array 64. The gradient vector array 64 is formed from a plurality of gradient vectors S corresponding to a plurality of coordinates. As described, each gradient vector S is defined by the gradient magnitude Gx in the x direction and the gradient magnitude Gy in the y direction.

FIG. 8 exemplifies a gradient map 66. The gradient map 66 is formed from a plurality of gradient information corresponding to a plurality of coordinates. In the embodiment of the present disclosure, each set of gradient information is formed from the x-direction gradient magnitude Gx and the y-direction gradient magnitude Gy, as described above.

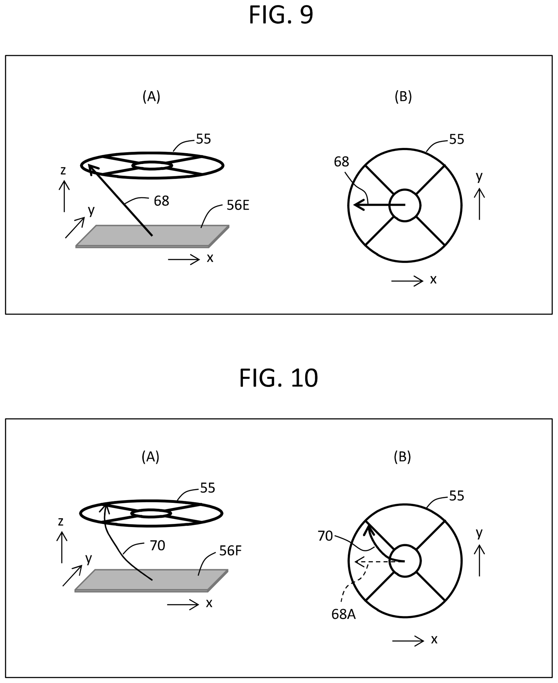

Next, necessity of correction of the gradient map and a method of correcting the gradient map will be described with reference to FIGs. 9 to 11.

FIG. 9 shows a model of a trajectory of the backscattered electrons of the related art. A part (A) shows a perspective diagram, and a part (B) shows a plan view. Backscattered electrons emitted from a micro-surface 56E fly in a straight line (refer to reference numeral 68), and reach a particular position on the detection surface 55. In the related art, the gradient information of the micro-surface is calculated based on such a presumption.

However, the above-described model is not necessarily applicable, depending on the sample observation condition. For example, when the acceleration voltage is high, the strength of the leakage magnetic field becomes large. When the WD is small, the influence of the leakage magnetic field to the backscattered electrons becomes more significant. When a particular objective lens is used, the strength of the leakage magnetic field becomes large. In such cases, a deflection action is applied to the backscattered electrons moving in the leakage magnetic field.

FIG. 10 shows a model of the trajectory of the backscattered electrons, taking into consideration the influences of the leakage magnetic field from the objective lens. A part (A) shows a perspective diagram, and a part (B) shows a plan view. When the leakage magnetic field acts on the backscattered electrons emitted from a micro-surface 56F, a rotational force about an axis parallel to the optical axis is caused on the backscattered electrons, and the trajectory of the backscattered electrons becomes an arc shape (refer to reference numeral 70). The backscattered electrons would thus reach a position different from an expected reaching point when the straight-line trajectory (refer to reference numeral 68A) is presumed. As a result, the gradient information calculated for each coordinate in the scanning region becomes inaccurate; that is, an azimuth angle error included in the gradient information increases. When the three-dimensional shape is reconstructed based on a gradient map including such an error, a distortion is generated in the three-dimensional shape.

In consideration of this, in the embodiment of the present disclosure, the gradient map is corrected using azimuth angle correction information corresponding to the current sample observation condition. In a first example configuration, the azimuth angle correction information is, for example, an azimuth angle correction value φc which is applied in common to a plurality of coordinates; that is, to a plurality of micro-surfaces. The azimuth angle correction value φc is determined in advance through an experiment or a simulation. This process will be described later.

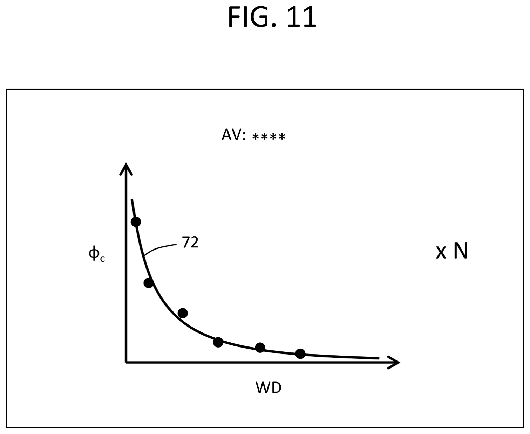

In the first example configuration, for example, as shown in FIG. 11, a correction function 72 is prepared for each acceleration voltage (AV). The horizontal axis shows the WD and the vertical axis shows the azimuth angle correction value φc. The correction function 72 is merely exemplary. For example, N correction functions 72 corresponding to N acceleration voltages are prepared. N is an integer greater than or equal to 2. From the N correction functions 72, a particular correction function 72 corresponding to the current acceleration voltage is selected, and the current WD is supplied to the particular correction function 72, to thereby determine the azimuth angle correction value φc. Alternatively, the azimuth angle correction value φc may be determined based on a plurality of correction functions 72 corresponding to the current acceleration voltage.

Based on the determined azimuth angle correction value φc, the x-direction gradient magnitude Gx and the y-direction gradient magnitude Gy are corrected according to following Equations (2-1) and (2-2).

[Equation 2]

$$G_x' = G_x \cos \varphi_c + G_y \sin \varphi_c \qquad \dots (2\text{-}1)$$

$$G_y' = G_x \sin \varphi_c - G_y \cos \varphi_c \qquad \dots (2\text{-}2)$$

A parameter Gx' represents a corrected gradient magnitude in the x direction, and a parameter Gy' represents a corrected gradient magnitude in the y direction.

With the above-described correction, the azimuth angle error caused by the leakage magnetic field may be reduced or removed. By correcting the gradient information for each coordinate in the scanning region, a corrected gradient map is acquired.

As will be described later, the correction function 72 illustrated in FIG. 11 is determined as a function which approximates a plurality of correction values determined through an experiment or a simulation. Alternatively, a correction function including two parameters; that is, the acceleration voltage and the WD, may be used. Alternatively, the azimuth angle correction value may be determined based on one of the acceleration voltage or the WD. Alternatively, the azimuth angle correction value may be determined based on three or more parameters, including the acceleration voltage and the WD.

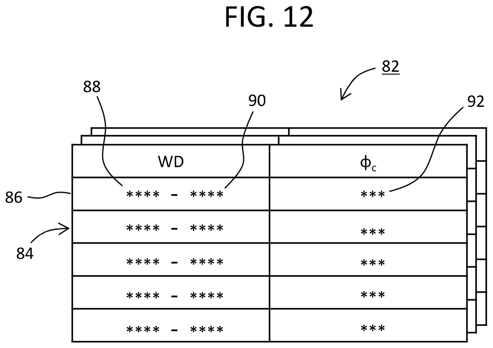

FIG. 12 shows a group 82 of correction tables according to the first example configuration. The group 82 of correction tables is used in place of the group of correction functions. The group 82 of correction tables corresponds to a database, and is formed from a plurality of correction tables 84 corresponding to a plurality of acceleration voltages. Each correction table 84 is formed from a plurality of records 86 corresponding to a plurality of WD intervals. Each record 86 has two numerical values 88 and 90 respectively defining an upper limit and a lower limit of the WD interval, and also has an azimuth angle correction value φc 92 corresponding to the WD interval. A particular azimuth angle correction value φc may be determined from the current sample observation condition based on such a group 82 of correction tables.

Alternatively, in the correction table 84, a plurality of WDs may be registered in place of the plurality of WD intervals. In this case, two WDs close to the current WD may be identified, and an azimuth angle correction value to be actually used may be identified through weighted interpolation of two azimuth angle correction values corresponding to the two identified WDs.

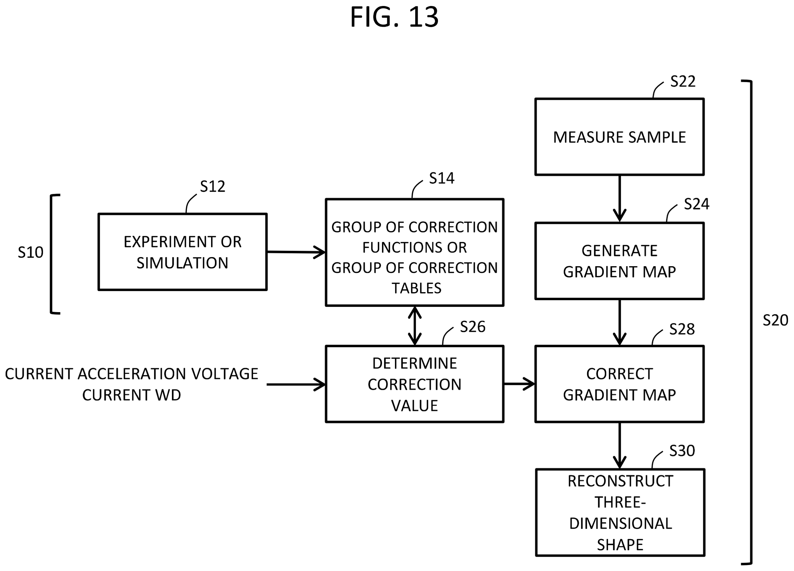

FIG. 13 shows an operation or a process of the embodiment as a flowchart. S10 shows processes executed in advance, and S20 shows processes executed during the sample measurement.

S10 includes S12 and S14. In S12, experiments or simulations are repeatedly executed while changing the sample observation condition (a combination of the acceleration voltage and the WD). With this process, in S14, a group of correction functions formed from a plurality of correction functions corresponding to a plurality of sample observation conditions is generated, or a group of correction tables formed from a plurality of correction tables corresponding to a plurality of sample observation conditions is generated. The group of correction functions or the group of correction tables is registered in the memory serving as the storage unit.

S20 includes S22 to S30. In S22, a sample is measured. In S24, a gradient map is generated. S22 and S24 may be executed simultaneously, or S24 may be executed after completion of execution of S22. In S26, an azimuth angle correction value is determined based on a combination of a current acceleration voltage and a current WD. In this process, a particular correction function or a particular correction table stored in the memory is used.

In S28, the gradient map is corrected based on the determined azimuth angle correction value. In S30, a three-dimensional shape is reconstructed based on the corrected gradient map.

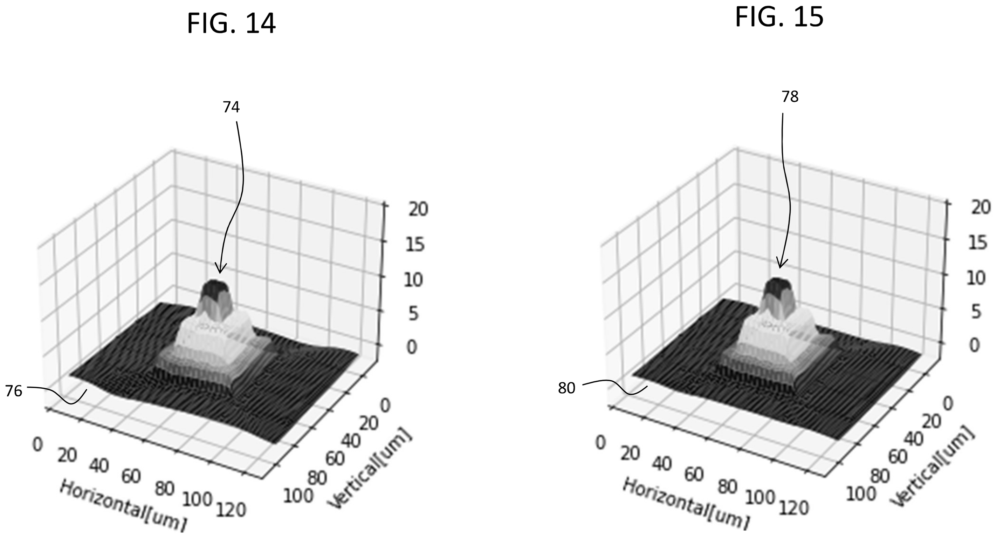

FIG. 14 shows a three-dimensional shape 74 reconstructed based on the gradient map before correction. FIG. 15 shows a three-dimensional shape 78 reconstructed based on the corrected gradient map. In FIGs. 14 and 15, the vertical axis is a height axis.

In the three-dimensional shape 74, a portion indicated by reference numeral 76 has relatively large warping. Other portions in the three-dimensional shape 74 also have relatively large warping. On the other hand, in the three-dimensional shape 78, warping at a portion indicated by reference numeral 80 is relatively small. Warping in the other portions of the three-dimensional shape 78 is also relatively small. In this manner, by correcting the gradient map, a result of the process using the corrected gradient map can be improved.

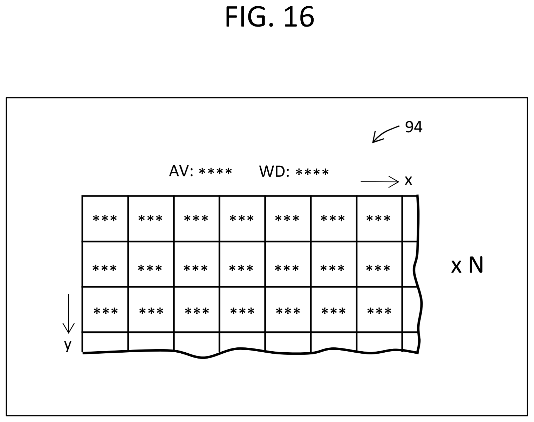

FIG. 16 shows a correction table 94 according to a second example configuration. In the second example configuration, the structure shown in FIG. 1 is used. In the second example configuration, for each coordinate in the scanning region, a different azimuth angle correction value is determined. For example, when the semi-in-lens is used, the strength of the leakage magnetic field tends to vary within the scanning region. In such cases, employing the second example configuration is desired.

More specifically, based on m acceleration voltages and n WDs, N combinations are defined, wherein N = m x n. Both of the values m and n are integers greater than or equal to 2. In the second example configuration, N correction tables 94 corresponding to N combinations are generated in advance, and are registered in the memory. Each correction table 94 has a plurality of azimuth angle correction values $\varphi c$ corresponding to a plurality of coordinates.

In the correction of the gradient map, first, a particular correction table 94 corresponding to a combination of the current acceleration voltage and the current WD is selected from the N correction tables 94. Next, according to the particular correction table 94, for each coordinate, an azimuth angle correction value corresponding to the coordinate is determined. The gradient information corresponding to the coordinate is then corrected using the determined azimuth angle correction value. Alternatively, one or a plurality of correction functions may be used in place of the plurality of correction tables 94.

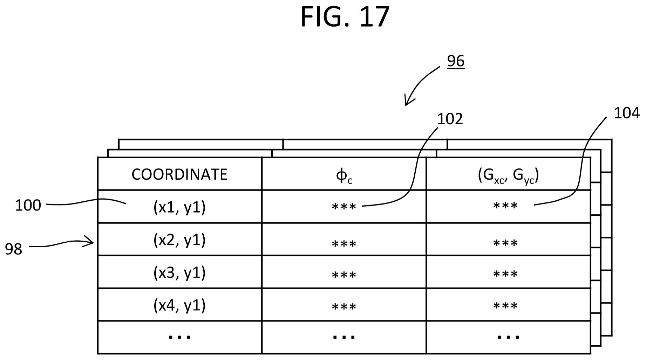

FIG. 17 shows a group 96 of correction tables according to a third example configuration. In the third example configuration, the structure shown in FIG. 1 is used. In the scanning region, an angle of incidence of the electron beam varies depending on the coordinate. With the change in the angle of incidence of the electron beam, an inclination angle error different from the azimuth angle error is caused. In consideration of this, in the third example configuration, both azimuth angle correction and inclination angle correction are executed during correction of the gradient map.

Similar to the configuration described above, based on m acceleration voltages and n WDs, N (= m x n) combinations are defined. The group 96 of correction tables is formed from N correction tables 98 corresponding to the N combinations. Each correction table 98 is formed from a plurality of records corresponding to a plurality of coordinates 100. Each record includes an azimuth angle correction value $\varphi c$ (refer to reference numeral 102), and an inclination angle correction value (Gxc, Gyc) (refer to reference numeral 104).

In the third example configuration, based on the combination of the current acceleration voltage and the current WD, a particular correction table 98 is selected from the group 96 of correction tables. Using the particular correction table 98, the azimuth angle is corrected and the inclination angle is corrected for each coordinate.

For example, in the correction of the azimuth angle, above-described Equations (2-1) and (2-2) are used, and, in the correction of the inclination angle, following Equations (3-1) and (3-2) are used.

[Equation 3]

$$G_x'' = G_x - G_{xc} \qquad \cdots (3\text{-}1)$$

$$G_y'' = G_y - G_{yc} \qquad \cdots (3\text{-}2)$$

A parameter Gx" represents a corrected amount of gradient in the x direction. A parameter Gy" represents a corrected amount of gradient in the y direction. The inclination angle may be corrected after the correction of the azimuth angle, or the azimuth angle may be corrected after the correction of the inclination angle. Alternatively, the azimuth angle and the inclination angle may be corrected simultaneously.

Next, a method of calculating the azimuth angle correction value and the inclination angle correction value will be described.

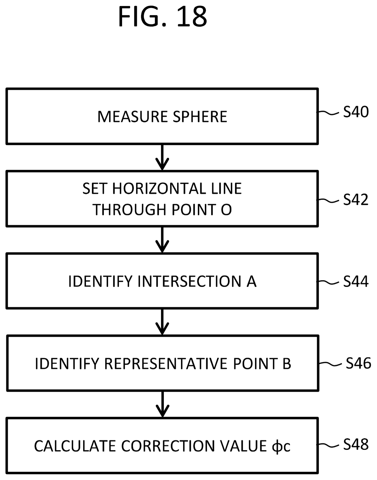

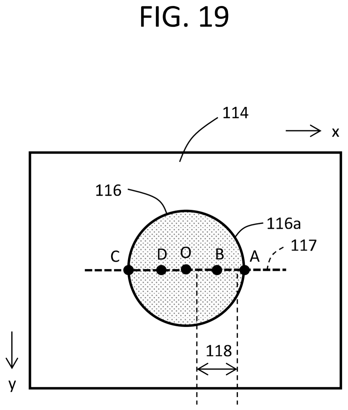

FIGs. 18 and 19 show a method of calculating the azimuth angle correction value through an experiment. This calculation method is used to calculate the azimuth angle correction value used in the first example configuration described above. A sample observation condition identical to a sample observation condition which is to be set in a future sample measurement is set, and the azimuth angle correction value is calculated under the set sample observation condition. Alternatively, a plurality of azimuth angle correction values are calculated while changing the sample observation condition. The method will now be described in detail.

In the scanning region of the electron beam, a sphere is placed as the sample. The sphere is actually placed on a sample base. The sphere is desirably a true sphere. Alternatively, an ellipsoid or the like may be used in place of the true sphere. A diameter of the sphere is, for example, 3/10 of a short side of the scanning region. In the scanning region including the sphere, the electron beam is two-dimensionally scanned (refer to S40). Based on a detection value set for each coordinate acquired in this process, a backscattered electron image is generated as an SEM image, and the gradient map is generated.

FIG. 19 shows a backscattered electron image 114 generated through an experiment. The backscattered electron image 114 includes a sphere image 116. A center O of the sphere image 116 is identified, and a horizontal line passing through the center O is defined (refer to S42). A point (intersection) A at which the horizontal line crosses an outline 116a of the sphere image 116 is identified (refer to S44). In the backscattered electron image 114, a predetermined point (representative point) B between the center O and the point A is identified (refer to S46). The representative point B is, for example, a middle point between the center O and the point A.

From the gradient map generated through the sample measurement, the x-direction gradient amount Gx and the y-direction gradient amount Gy are extracted as the gradient information corresponding to the point B. When there is no influence of the leakage magnetic field, the y-direction gradient magnitude Gy is zero. On the contrary, when there is an influence of the leakage magnetic field, a y-direction gradient magnitude Gy is caused, which increases as a degree of influence of the leakage magnetic field becomes larger. A magnitude of the deflection action due to the leakage magnetic field (that is, the azimuth angle error) can be estimated based on the y-direction gradient magnitude Gy (refer to S48).

For example, the azimuth angle correction value φc is determined based on following Equation (4).

[Equation 4]

$$\varphi_c = -\tan^{-1} \frac{G_y}{G_x} \quad \ldots (4)$$

The above-described azimuth angle correction value φc cancels the azimuth angle error. In the first example configuration, the azimuth angle correction value φc determined in this manner is applied in common to all coordinates (that is, all micro-surfaces).

Alternatively, in FIG. 19, a plurality of azimuth angle correction values may be calculated within a certain interval 118 between the center O and the intersection A, and an average value calculated from the plurality of azimuth angle correction values may be taken as the azimuth angle correction value to be actually used. Alternatively, in addition to the azimuth angle correction value corresponding to the point B, an azimuth angle correction value corresponding to a point D may be calculated, and an average value determined from the two azimuth angle correction values may be taken as the azimuth angle correction value to be actually used. The point D is, for example, a middle point between the center O and an intersection C. The intersection C is a point at which the horizontal line 117 intersects the outline 116a, and is a point at an opposite side when viewed from the point A.

Alternatively, a vertical line may be defined in place of the horizontal line 117, and an azimuth angle correction value may be calculated using the vertical line. Alternatively, an average value may be calculated based on a first azimuth angle correction value corresponding to a representative point on the horizontal line 117, and a second azimuth angle correction value corresponding to a representative point on the vertical line, and the average value may be taken as the azimuth angle correction value to be actually used.

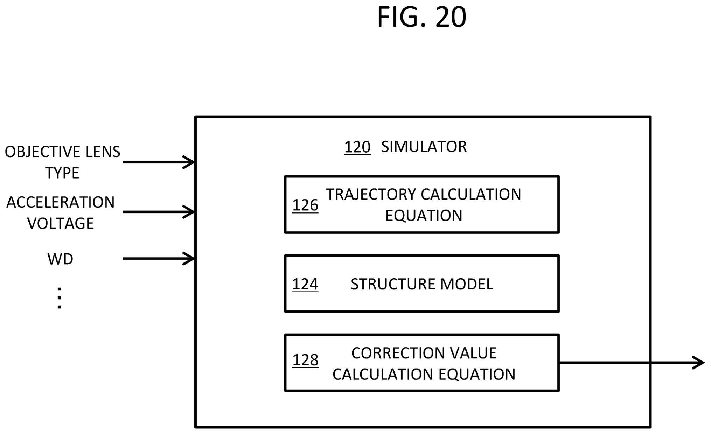

FIG. 20 shows a method of calculating the azimuth angle correction value through a simulation. The calculation method calculates the azimuth angle correction value used in the first example configuration described above. A sample observation condition identical to a sample observation condition which is to be set in a future sample measurement is set, and an azimuth angle correction value is calculated under the set sample observation condition. Alternatively, a plurality of azimuth angle correction values are calculated while changing the sample observation condition. The process will now be described in detail.

In FIG. 20, a simulator 120 is formed from, for example, a computer. The simulator 120 has a structure model 124, a trajectory calculation equation 126, a correction value calculation equation 128, and the like. The structure model 124 includes an objective lens model, a detector model, a sample model, and the like. A user designates an objective lens type, and also designates a group of parameters such as the acceleration voltage and the WD.

The simulator 120 calculates a trajectory of backscattered electrons emitted from the sample based on the input information and using the trajectory calculation equation 126. Then, the simulator 120 calculates an azimuth angle correction value based on the calculated trajectory and using the correction value calculation equation 128. The azimuth angle correction value is registered in the memory in the scanning electron microscope.

When the second example configuration described above is to be executed, prior to the execution, an azimuth angle correction value array may be calculated through experiments, as described below.

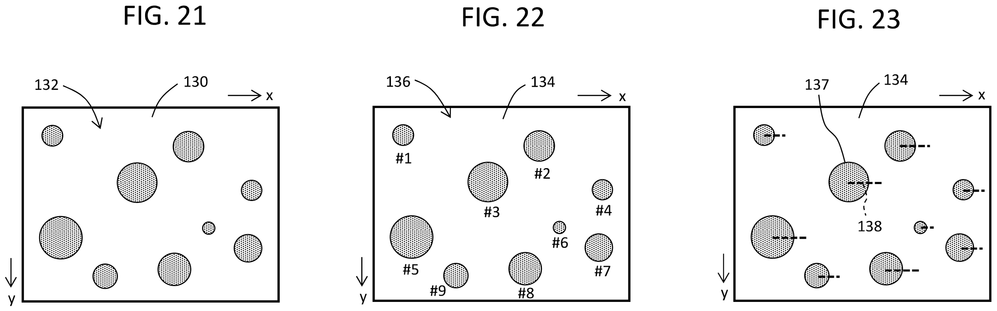

As shown in FIG. 21, a group of spheres 132 is placed in a distributed manner in a scanning region 130. Ideally, the group of spheres 132 is placed so that a plurality of spheres are uniformly distributed over the entirety of the scanning region 130. Desirably, a diameter of each sphere is set to be 10% or less of a length of a short side of the scanning region 130. In the illustrated example configuration, the group of spheres 132 is formed from a plurality of spheres having various sizes. Alternatively, a plurality of spheres having the same size may be used.

After the group of spheres 132 is placed, an electron beam is two-dimensionally scanned in the scanning region 130. Based on a detection value set for each coordinate acquired through this process, a backscattered electron image is generated, and a gradient map is generated.

FIG. 22 shows a backscattered electron image 134 which is generated. The backscattered electron image 134 includes a group of sphere images 136. A labeling process is applied to the backscattered electron image 134. With this process, each sphere image is extracted as an isolated region, and a label (#1 to #9) is attached to each sphere image.

As shown in FIG. 23, in the backscattered electron image 134 after the labeling process, for each spherical image 137, a horizontal line 138 which passes through a center of the sphere image 137 is defined. Similar to the above, an intersection at which the horizontal line 138 intersects an outline of the sphere image 137 is identified. An azimuth angle correction value is calculated from gradient information corresponding to a predetermined point between the center and the intersection.

In the manner described above, a plurality of azimuth angle correction values corresponding to a plurality of representative coordinates in the scanning region are determined. The plurality of azimuth angle correction values are mapped on an x-y-$\varphi$c coordinate system, and are approximated with a curved surface (polynomial equation), so as to determine a correction function including the coordinate x and the coordinate y as variables. The correction function is used in the second example configuration described above. Alternatively, the correction function or a correction table corresponding thereto may be determined through a simulation.

Based on the azimuth angle correction value for each coordinate determined in the above-described manner, or on an inclination angle correction value which is determined through a process described below, the correction function or the correction table used in the third example configuration may be generated. In this case, a plurality of correction functions or a plurality of correction tables are generated while changing the sample observation condition.

When the inclination angle correction value is calculated through an experiment, first, a planar sample extending over the entirety of the scanning region is placed on the sample base. The planar sample is a sample having an upper surface which is a completely planar surface (horizontal surface). Then, an electron beam is two-dimensionally scanned in the scanning region. With this process, a detection value set is acquired for each coordinate. Based on the detection value set for each coordinate, gradient information; that is, the x-direction gradient magnitude Gx and the y-direction gradient magnitude Gy, are determined.

As the gradient magnitudes Gx and Gy correspond to the inclination angle error derived from the angle of incidence of the electron beam, an inclination angle correction value (Gxc, Gyc) is determined from following Equations (5-1) and (5-2).

[Equation 5]

$$G_{xc} = G_x \qquad \dots (5\text{-}1)$$

$$G_{yc} = G_y \qquad \dots (5\text{-}2)$$

The inclination angle correction value (Gxc, Gyc) corresponds to the inclination angle correction value θc in the following manner.

[Equation 6]

$$\theta_c = \sqrt{(G_{xc}^2 + G_{yc}^2)} \qquad \dots (6)$$

When above-described Equations (3-1) and (3-2) are used during the inclination angle correction, the inclination angle correction value (Gxc, Gyc) is used. When the value of θ is directly corrected during the inclination angle correction, the inclination angle correction value θc is used. Alternatively, the group of correction functions or the group of correction tables for the third example configuration may be generated through a simulation.

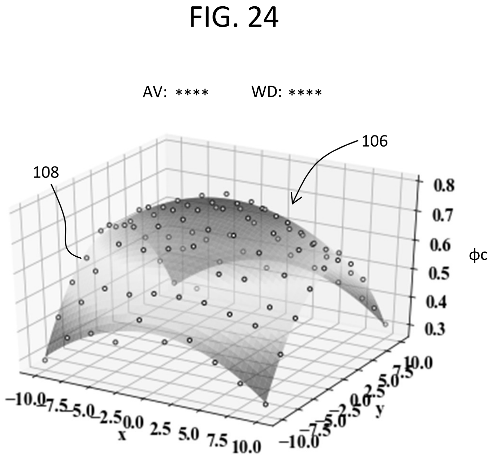

FIG. 24 shows a correction function 106 which may be used in the second example configuration and the third example configuration. The first horizontal axis is an x axis, and the second horizontal axis is a y axis. The vertical axis is an axis showing the azimuth angle correction value $\varphi$c. The correction function 106 is defined as a curved surface approximating a plurality of actually measured values (azimuth angle correction values) 108 determined through an experiment or a simulation. In reality, a plurality of correction functions 106 corresponding to a plurality of sample observation conditions are generated.

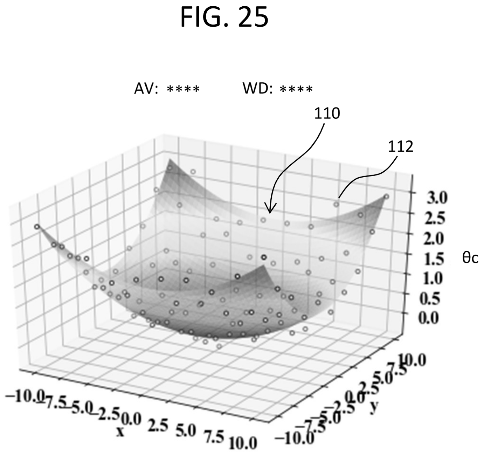

FIG. 25 shows a correction function 110 which may be used in the third example configuration. The first horizontal axis is the x axis, and the second horizontal axis is the y axis. The vertical axis is an axis showing the inclination angle correction value θc. The correction function 110 is defined as a curved surface approximating a plurality of actually measured values (inclination angle correction values) 112 determined through an experiment or a simulation. In reality, a plurality of correction functions 110 corresponding to a plurality of sample observation conditions are generated.

The method of generating the gradient map including the gradient map correction as described above may be performed on a charged particle beam apparatus other than the electron microscope. In the above-described embodiment, the acceleration voltage and the WD are used as the sample observation condition, but alternatively, it may be the case that only one of these parameters is used. Alternatively, three or more parameters related to the errors in the gradient information may be used as the sample observation condition. In the above-described embodiment, in the correction of the gradient map, each set of gradient information is corrected so that at least the azimuth angle is corrected. When the inclination angle error varies depending on a composition of the sample, the composition may be estimated for each coordinate, and the inclination angle may be corrected based on the estimated composition.

**Claims**

1. A scanning electron microscope comprising:

   a detector (22) that detects electrons emitted from each micro-surface of a sample during a process of scanning an electron beam on the sample, and that has a plurality of detection regions;
   a calculator (41) that calculates a gradient map formed from a plurality of sets of gradient information representing gradient states of a plurality of micro-surfaces of the sample, based on a plurality of detection signals which are output from the plurality of detection regions; and
   a corrector (42) that corrects the gradient map, wherein
   each of the sets of gradient information includes information which identifies an azimuth angle of each of the micro-surfaces, and
   the corrector (42) corrects each of the sets of gradient information so that the azimuth angle of each of the micro-surfaces is corrected according to a current sample observation condition.

2. The scanning electron microscope according to claim 1, wherein
   the correction of the azimuth angle of each of the micro-surfaces is a correction to reduce an azimuth angle error caused by a leakage magnetic field from an objective lens (20) acting on the electrons emitted from each of the micro-surfaces.

3. The scanning electron microscope according to claim 1, wherein
   the corrector (42) corrects each of the sets of gradient information based on azimuth angle correction information corresponding to the current sample observation condition.

4. The scanning electron microscope according to claim 3, wherein
   the azimuth angle correction information includes an azimuth angle correction value which is applied common to the plurality of micro-surfaces.

5. The scanning electron microscope according to claim 3, wherein
   the azimuth angle correction information includes a plurality of azimuth angle correction values which are applied to the plurality of micro-surfaces.

6. The scanning electron microscope according to claim 3, wherein
   the azimuth angle correction information is information acquired in advance through an experiment or a simulation under a sample observation condition corresponding to the current sample observation condition, or information generated from the information acquired in advance.

7. The scanning electron microscope according to claim 3, further comprising

   a storage unit (49) that stores a plurality of sets of azimuth angle correction information acquired by repeating experiments or simulations while sequentially setting a plurality of sample observation conditions, wherein
   the corrector (42) identifies the azimuth angle correction information corresponding to the current sample observation condition based on the plurality of sets of azimuth angle correction information.

8. The scanning electron microscope according to any one of claims 3 to 8, wherein
the current sample observation condition includes at least one of an acceleration voltage or a working distance.

9. The scanning electron microscope according to any preceding claim, wherein

each of the sets of gradient information further includes information which identifies an inclination angle of each of the micro-surfaces, and
the corrector (42) corrects each of the sets of gradient information so that both the azimuth angle and the inclination angle of each of the micro-surfaces are corrected.

10. The scanning electron microscope according to claim 9, wherein
the corrector (42) corrects each of the sets of gradient information so that the inclination angle of each of the micro-surfaces is corrected based on an inclination angle correction value corresponding to each of the micro-surfaces.

11. A method of generating a gradient map, the method comprising:

detecting (S22), with a plurality of detection regions, electrons emitted from each micro-surface of a sample during a process of scanning a charged particle beam on the sample; and
generating (S24) a gradient map formed from a plurality of sets of gradient information representing gradient states of a plurality of micro-surfaces of the sample, based on a plurality of detection signals which are output from the plurality of detection regions, wherein
each of the sets of gradient information includes information which identifies an azimuth angle of each of the micro-surfaces, and
in the generating (S24) the gradient map, each of the sets of gradient information is corrected so that the azimuth angle of each of the micro-surfaces is corrected according to a current sample observation condition.

FIG. 1

# FIG. 3

# FIG. 2

# FIG. 4

EP 4 726 769 A1

## FIG. 5

EP 4 726 769 A1

EP 4 726 769 A1

## FIG. 6

## FIG. 7

S: (Gx, Gy)

64

## FIG. 8

66

| COORDINATE | Gx | Gy |
|---|---|---|
| (x1, y1) | **** | **** |
| (x2, y1) | **** | **** |
| (x3, y1) | **** | **** |
| ... | ... | .... |

FIG. 9

FIG. 10

# FIG. 11

AV: ****

$\phi_c$

72

WD

x N

EP 4 726 769 A1

# FIG. 12

EP 4 726 769 A1

| WD | $\phi_c$ |
|---|---|
| **** - **** | *** |
| **** - **** | *** |
| **** - **** | *** |
| **** - **** | *** |
| **** - **** | *** |

# FIG. 13

S10
- EXPERIMENT OR SIMULATION (S12) → GROUP OF CORRECTION FUNCTIONS OR GROUP OF CORRECTION TABLES (S14)

S20
- MEASURE SAMPLE (S22) → GENERATE GRADIENT MAP (S24) → CORRECT GRADIENT MAP (S28) → RECONSTRUCT THREE-DIMENSIONAL SHAPE (S30)

CURRENT ACCELERATION VOLTAGE CURRENT WD → DETERMINE CORRECTION VALUE (S26)

FIG. 14

FIG. 15

EP 4 726 769 A1

# FIG. 16

EP 4 726 769 A1

## FIG. 17

| COORDINATE | $\phi_c$ | $(G_{xc}, G_{yc})$ |
|---|---|---|
| (x1, y1) | *** | *** |
| (x2, y1) | *** | *** |
| (x3, y1) | *** | *** |
| (x4, y1) | *** | *** |
| ... | ... | ... |

# FIG. 18

EP 4 726 769 A1

```
┌─────────────────────────────┐
│      MEASURE SPHERE         │──── S40
└─────────────────────────────┘
              │
              ▼
┌─────────────────────────────┐
│    SET HORIZONTAL LINE      │──── S42
│      THROUGH POINT O        │
└─────────────────────────────┘
              │
              ▼
┌─────────────────────────────┐
│    IDENTIFY INTERSECTION A  │──── S44
└─────────────────────────────┘
              │
              ▼
┌─────────────────────────────┐
│ IDENTIFY REPRESENTATIVE POINT B │──── S46
└─────────────────────────────┘
              │
              ▼
┌─────────────────────────────┐
│ CALCULATE CORRECTION VALUE $\phi c$ │──── S48
└─────────────────────────────┘
```

# FIG. 19

EP 4 726 769 A1

# FIG. 20

OBJECTIVE LENS TYPE →

ACCELERATION VOLTAGE →

WD →

⋮

**120   SIMULATOR**

| 126 | TRAJECTORY CALCULATION EQUATION |

| 124 | STRUCTURE MODEL |

| 128 | CORRECTION VALUE CALCULATION EQUATION | →

FIG. 21

FIG. 22

FIG. 23

EP 4 726 769 A1

FIG. 24

# FIG. 25

EP 4 726 769 A1

Europäisches Patentamt
European Patent Office
Office européen des brevets

# EUROPEAN SEARCH REPORT

Application Number

EP 25 20 6103

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2022/392738 A1 (OTSUKA TAKESHI [JP]) 8 December 2022 (2022-12-08) * abstract * * paragraph [0001] - paragraph [0159] * * figure 1 * ----- | 1-11 | INV. H01J37/28 H01J37/244 |
| | | | TECHNICAL FIELDS SEARCHED (IPC) |
| | | | H01J |

The present search report has been drawn up for all claims

| Place of search | Date of completion of the search | Examiner |
|---|---|---|
| Munich | 2 March 2026 | Bridi, Dorian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

32

## ANNEX TO THE EUROPEAN SEARCH REPORT
## ON EUROPEAN PATENT APPLICATION NO.

EP 25 20 6103

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2026

| Patent document cited in search report | Publication date | Patent family member(s) | Publication date |
|---|---|---|---|
| US 2022392738 A1 | 08-12-2022 | EP 4099359 A1 | 07-12-2022 |
| | | JP 7323574 B2 | 08-08-2023 |
| | | JP 2022185757 A | 15-12-2022 |
| | | US 2022392738 A1 | 08-12-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006172919 A

- JP 2022185757 A